# EUROPEAN PATENT APPLICATION

(11) **EP 4 255 140 A1**
(43) Date of publication of application: **04.10.2023**
(21) Application number: 21905361.8
(22) Date of filing: 05.11.2021
(51) Int. Cl.: H05K 7/20

(54) **ELECTRONIC DEVICE**

(30) Priority: 15.12.2020 CN 202011478901
(71) Applicant: Huawei Technologies Co., Ltd., Shenzhen, Guangdong 518129 (CN)
(72) Inventor: PENG, Yaofeng, Shenzhen, Guangdong 518129 (CN)
(74) Representative: Maiwald GmbH
(86) International application number: PCT/CN2021/129084
(87) International publication number: WO 2022/127432

(57) **Abstract**

This application discloses an electronic device, and relates to the field of heat dissipation technologies. The electronic device includes a heat dissipation housing (1), a circuit board (2), a chip (3), a thermal interface material layer (4), a heat conducting member (5), and an elastic member (6). The circuit board (2), the chip (3), the heat conducting member (5), and the elastic member (6) are located in a chamber (101) formed by the heat dissipation housing (1). The chip (3) is located on a surface of the circuit board (2). The heat conducting member (5) is located on a surface of the chip (3). The elastic member (6) having a heat transfer property is compressed between the heat conducting member (5) and a first housing wall (11), to reduce a gap between the chip (3) and the heat conducting member (5). The gap is filled with the thermal interface material layer (4). The thin thermal interface material layer (4) filled in the gap can accelerate heat transfer between the chip (3) and the heat conducting member (5), so that the heat conducting member (5) can quickly transfer absorbed heat to the heat dissipation housing (1), to enhance heat dissipation effect.

## Description

This application claims priority to Chinese Patent Application No. 202011478901.3, filed on December 15, 2020 and entitled "ELECTRONIC DEVICE", which is incorporated herein by reference in its entirety.

### TECHNICAL FIELD

This application relates to the field of heat dissipation technologies, and in particular, to a heat dissipation architecture of an electronic device.

### BACKGROUND

An electronic device, like a vehicle-mounted device of an autonomous vehicle, may structurally include a chip and a heat dissipation housing. The chip is disposed in the heat dissipation housing. The heat dissipation housing is configured to seal the chip to achieve dustproof and waterproof effect, and dissipate heat of the chip.

Because the chip has a high tolerance during processing, and a housing wall and a base of the heat dissipation housing each have a thickness tolerance during processing of the heat dissipation housing, a gap between the chip and the housing wall of the heat dissipation housing is usually large, and needs to be filled with a thick thermal interface material layer, for example, usually a thermal interface material layer with a thickness of about 1 millimeter. The thermal interface material layer can eliminate the large gap between the chip and the housing wall of the heat dissipation housing, reduce thermal resistance caused by air, improve heat transfer effect, and accelerate heat dissipation for the chip.

Although the thick thermal interface material layer filled between the chip and the heat dissipation housing can eliminate the gap and reduce the thermal resistance caused by air, the thick thermal interface material layer itself has large thermal resistance, resulting in poor heat transfer improvement effect. Consequently, heat dissipation effect of the electronic device is still poor.

### SUMMARY

This application provides an electronic device, to overcome a problem in a related technology. The technical solutions are as follows.

According to one aspect, an electronic device is provided. The electronic device includes a heat dissipation housing, a circuit board, a chip, a heat conducting member, and an elastic member. The circuit board, the chip, the heat conducting member, and the elastic member are all located in a chamber formed by the heat dissipation housing. The chip is located on a surface of the circuit board. The heat conducting member is located on a surface that is of the chip and that is away from the circuit board. The elastic member is compressed between a surface that is of the heat conducting member and that is away from the chip and an inner surface of a first housing wall of the heat dissipation housing, to reduce a gap between the chip and the heat conducting member. The elastic member has a heat transfer property. The first housing wall is a housing wall that is of the heat dissipation housing and that is opposite to the chip in position.

In an example, the elastic member is compressed between the heat conducting member and the first housing wall, so that a large portion of the gap between the chip and the heat conducting member can be eliminated, and the chip and the heat conducting member can fit more closely to each other. Once the degree of adhesion between the chip and the heat conducting member fit more closely to each other, heat transfer between the chip and the heat conducting member is accordingly faster, so that the heat conducting member can quickly absorb heat of the chip, and transfer the absorbed heat to the heat dissipation housing by using the elastic member having the heat transfer property, to further improve heat dissipation effect of the electronic device.

In a possible implementation, the electronic device further includes a thermal interface material layer. The thermal interface material layer is filled in the gap between the chip and the heat conducting member.

In an example, the elastic member is compressed between the heat conducting member and the first housing wall, so that the large portion of the gap between the chip and the heat conducting member can be eliminated, and a thickness of the thermal interface material layer filled between the chip and the heat conducting member can be reduced. Once the thickness of the thermal interface material layer is reduced, thermal resistance of the thermal interface material layer is also reduced. Once the thermal resistance of the thermal interface material layer is reduced, heat transfer from the chip to the thermal interface material layer to the heat conducting member can be faster, so that the heat conducting member can quickly absorb the heat of the chip, and sequentially transfer the absorbed heat to the thermal interface material layer, the elastic member having the heat transfer property, and the heat dissipation housing, to further improve the heat dissipation effect of the electronic device.

In a possible implementation, the elastic member includes a spring and a heat pipe. The spring is compressed between the heat conducting member and the first housing wall, to reduce the gap between the chip and the heat conducting member. The heat pipe is connected between the heat conducting member and the first housing wall to transfer, to the heat dissipation housing, heat absorbed by the heat conducting member from the chip. The heat pipe has elasticity. The heat pipe is compressed between the surface that is of the heat conducting member and that is away from the chip and the inner surface of the first housing wall of the heat dissipation housing.

In an example, elastic force of the spring can eliminate the large portion of the gap between the chip and the heat conducting member, and make heat transfer between the chip and the heat conducting member faster. Heat transfer between the heat conducting member and a heat dissipation housing 1 can be faster through thermal conductivity of the heat pipe. It can be learned that, heat generated by the chip can be quickly transferred to the heat conducting member, and the heat absorbed by the heat conducting member can be quickly transferred to the heat dissipation housing by using the heat pipe, and dissipates outward by using the heat dissipation housing, to enhance effect of dissipating the heat of the chip.

In a possible implementation, the heat pipe includes a first pipe section, a second pipe section, and a third pipe section. The first pipe section is attached to the surface that is of the heat conducting member and that is away from the chip. The third pipe section is attached to the inner surface of the first housing wall. The second pipe section is obliquely connected between the first pipe section and the second pipe section.

In an example, because the second pipe section is inclined relative to the first pipe section and the third pipe section, and the heat pipe is made of metal and has ductility, a connecting part between the first pipe section and the second pipe section can be elastic and deformable, and a connecting part between the second pipe section and the third pipe section can be elastic and deformable, to implement the elasticity of the heat pipe without interfering with a telescopic movement of the spring.

In a possible implementation, the elastic member is a bent heat conduction sheet, and is compressed and disposed between the surface that is of the heat conducting member and that is away from the chip and the inner surface of the first housing wall. The elastic member provides elasticity through a bending characteristic, and transfers heat through a heat conduction characteristic.

In an example, the elastic member is a bent sheet, with a bent structure having telescopic elasticity. Because the elastic member is a heat conduction sheet and has the heat transfer property, the elastic member can be compressed between the heat conducting member and the first housing wall and can transfer heat between the heat conducting member and the first housing wall.

In a possible implementation, the circuit board is fastened to a housing wall of the heat dissipation housing.

In an example, the circuit board can be fastened in the chamber to provide supporting force for compressive elastic force of the elastic member. The circuit board may be fastened to any housing wall of the heat dissipation housing, for example, may be fastened to the first housing wall or a second housing wall.

According to another aspect, an electronic device is provided. The electronic device includes a heat dissipation housing, a circuit board, a chip, a thermal interface material layer, a heat conducting member, and an elastic member. The circuit board, the chip, the thermal interface material layer, the heat conducting member, and the elastic member are all located in a chamber formed by the heat dissipation housing. The chip is located on a surface of the circuit board. The heat conducting member is located on a surface that is of the chip and that is away from the circuit board. The elastic member is compressed between a surface that is of the heat conducting member and that is away from the chip and an inner surface of a first housing wall of the heat dissipation housing, to reduce a gap between the chip and the heat conducting member. The gap is filled with the thermal interface material layer. The elastic member has a heat transfer property. The first housing wall is a housing wall that is of the heat dissipation housing that is opposite to the chip in position.

In an example, the elastic member is compressed between the heat conducting member and the first housing wall, so that a large portion of the gap between the chip and the heat conducting member can be eliminated, and a thickness of the thermal interface material layer filled between the chip and the heat conducting member can be reduced. Once the thickness of the thermal interface material layer is reduced, thermal resistance of the thermal interface material layer is also reduced. Once the thermal resistance of the thermal interface material layer is reduced, heat transfer from the chip to the thermal interface material layer to the heat conducting member can be faster, so that the heat conducting member can quickly absorb heat of the chip, and sequentially transfer the absorbed heat to the thermal interface material layer, the elastic member having the heat transfer property, and the heat dissipation housing, to further improve heat dissipation effect of the electronic device.

According to another aspect, an electronic device is provided. The electronic device includes a heat dissipation housing, a circuit board, a chip, an elastic member, and a heat dissipation apparatus. Both the circuit board and the chip are located in a chamber formed by the heat dissipation housing. The chip is located on a surface of the circuit board. A first housing wall of the heat dissipation housing has an opening at a position corresponding to the chip. The first housing wall is a housing wall that is of the heat dissipation housing and that is opposite to the chip in position. The heat dissipation apparatus includes a heat dissipation base and a mounting plate. The mounting plate is located on an outer surface of a side wall of the heat dissipation base. The heat dissipation base matches the opening, the heat dissipation base is detachably disposed in the opening, and the heat dissipation base is located on a surface that is of the chip and that is away from the circuit board. The mounting plate is located on an outer surface of the first housing wall. The elastic member is located on a surface that is of the mounting plate and that is away from the first housing wall. Both the elastic member and the mounting plate are fastened to the first housing wall by using a fastener. The elastic member is compressed between the fastener and the mounting plate, to reduce a gap between the chip and the heat dissipation base.

In an example, the elastic member is compressed between the top of the fastener and the mounting plate, so that a large portion of the gap between the chip and the heat dissipation base can be eliminated, and the chip and the heat dissipation base can fit more closely to each other. Once the chip and the heat dissipation base fit more closely to each other, heat transfer between the chip and the heat dissipation base is accordingly faster, so that the heat dissipation base can quickly absorb heat of the chip to dissipate the heat of the chip, to further improve heat dissipation effect of the electronic device.

In addition, in terms of a path for dissipating the heat of the chip, because the bottom of the mounting plate is closely attached to the outer surface of the first housing wall, the heat dissipation apparatus and the heat dissipation housing are thermally connected, so that heat absorbed by the heat dissipation base from the chip can also be transferred to the heat dissipation housing, to dissipate the heat of the chip by the heat dissipation housing. It can be learned that, one portion of heat generated by the chip is dissipated by the heat dissipation apparatus, and the another portion of heat is transferred to the heat dissipation housing by the heat dissipation apparatus, and is dissipated by the heat dissipation housing.

In a possible implementation, the electronic device further includes a thermal interface material layer. The thermal interface material layer is filled in the gap between the chip and the heat dissipation base. The elastic member can also reduce a thickness of the thermal interface material layer filled in the gap.

In an example, although the thermal interface material layer is filled between the chip and the heat dissipation base that are of the electronic device, because the elastic member in a compressed state that is disposed on an outer surface of the mounting plate applies pressing force to the heat dissipation base, the large portion of the gap between the chip and the heat dissipation base has been eliminated. In this case, only the thin thermal interface material layer needs to be filled in the gap. For example, the thickness of the filled thermal interface material layer is only 0.05 millimeter to 0.07 millimeter, or even smaller.

In addition, because the thin thermal interface material layer filled between the chip and the heat dissipation base has compression and deformation characteristics, and the elastic member applies the pressing force to the heat dissipation base, the thickness of the thermal interface material layer can be further compressed, so that the thermal interface material layer is further thinned. For example, the thermal interface material layer that is made of silica gel and with a thickness of 0.07 millimeter is selected and filled between the chip and the heat dissipation base. The thermal interface material layer is compressed by 0.02 millimeter in thickness again under a pressing action of the elastic member. In this case, the thickness of the thermal interface material layer finally filled between the chip and the heat dissipation base is 0.05 millimeter.

It can be learned that, the elastic member in the compressed state can eliminate the large portion of the gap between the chip and the heat dissipation base, and can greatly reduce the thickness of the thermal interface material layer filled between the chip and the heat dissipation base. Once the thickness of the thermal interface material layer is reduced, thermal resistance of the thermal interface material layer is also reduced. Once the thermal resistance of the thermal interface material layer is reduced, thermal conductivity of the thermal interface material layer can be improved, to further improve the heat dissipation effect of the electronic device.

In a possible implementation, a vapor chamber is disposed on a surface that is of the heat dissipation base and that is close to the chip.

In an example, the vapor chamber can further make heat transfer between the chip and the heat dissipation apparatus faster, and enhance effect of dissipating heat of the chip.

In a possible implementation, the heat dissipation apparatus further includes a heat dissipation fin, and the heat dissipation fin is located on a surface that is of the heat dissipation base and that is away from the chip.

In an example, the heat dissipation fin can increase a total heat dissipation area of the heat dissipation base, to accelerating heat dissipation for the chip.

In a possible implementation, the mounting plate is located at a root of a heat dissipation fin adjacent to the side wall of the heat dissipation base.

In an example, in a solution in which the heat dissipation fin is installed on an outer surface of the top of the heat dissipation base, the mounting plate on the outer surface of the side wall of the heat dissipation base can be fastened to the root of the heat dissipation fin. Certainly, the mounting plate may alternatively be located on an outer surface that is of the side wall of the heat dissipation base and that is close to the top of the heat dissipation base. A specific installation position of the mounting plate is not limited in this embodiment, provided that the bottom of the heat dissipation base can be located in the opening, and the mounting plate can be mounted on the outer surface of the first housing wall.

In a possible implementation, an end that is of the mounting plate and that is away from a side wall of the heat dissipation base is in contact with a housing heat dissipation fin of the heat dissipation housing.

In an example, the bottom of the mounting plate is in contact with the first housing wall, and the end of the mounting plate is in contact with the housing heat dissipation fin, so that a contact area between the mounting plate and the heat dissipation housing can be increased, to make heat transfer between the heat dissipation apparatus and the heat dissipation housing faster, and enhance the effect of dissipating the heat of the chip.

In a possible implementation, a seal is disposed between the side wall of the heat dissipation base and an inner wall of the opening.

In an example, when the heat dissipation base is installed in the opening of the heat dissipation housing, the seal is located between the side wall of the heat dissipation base and the inner wall of the opening, so that dust, water, and the like can be prevented from entering the chamber through a gap between an outer wall of the heat dissipation base and the inner wall of the opening.

In a possible implementation, the circuit board is fastened to a housing wall of the heat dissipation housing.

In an example, the circuit board can be fastened in the chamber to provide supporting force for compressive elastic force of the elastic member. The circuit board may be fastened to any housing wall of the heat dissipation housing, for example, may be fastened to the first housing wall or a second housing wall.

According to another aspect, an electronic device is provided. The electronic device includes a heat dissipation housing, a circuit board, a chip, a thermal interface material layer, an elastic member, and a heat dissipation apparatus. The circuit board, the chip, and the thermal interface material layer are all located in a chamber formed by the heat dissipation housing. The chip is located on a surface of the circuit board. A first housing wall of the heat dissipation housing has an opening at a position corresponding to the thermal interface material layer. The first housing wall is a housing wall that is of the heat dissipation housing and that is opposite to the chip in position. The heat dissipation apparatus includes a heat dissipation base and a mounting plate. The mounting plate is located on an outer surface of a side wall of the heat dissipation base. The heat dissipation base matches the opening, the heat dissipation base is detachably disposed in the opening, and the heat dissipation base is located on a surface that is of the chip and that is away from the circuit board. The mounting plate is located on an outer surface of the first housing wall. The elastic member is located on a surface that is of the mounting plate and that is away from the first housing wall. Both the elastic member and the mounting plate are fastened to the first housing wall by using a fastener. The elastic member is compressed between the fastener and the mounting plate, to reduce a gap between the chip and the heat dissipation base and reduce a thickness of a thermal interface material layer filled in the gap.

In an example, the elastic member in the compressed state can eliminate a large portion of the gap between the chip and the heat dissipation base, and can greatly reduce the thickness of the thermal interface material layer filled between the chip and the heat dissipation base. Once the thickness of the thermal interface material layer is reduced, thermal resistance of the thermal interface material layer is also reduced. Once the thermal resistance of the thermal interface material layer is reduced, thermal conductivity of the thermal interface material layer can be improved, to further improve heat dissipation effect of the electronic device.

According to another aspect, an electronic device is provided. The electronic device includes a heat dissipation housing, a circuit board, a chip, and an elastic member. The circuit board, the chip, and the elastic member are all located in a chamber formed by the heat dissipation housing. The chip is located on a surface of the circuit board. The elastic member is compressed between the circuit board and a second housing wall of the heat dissipation housing, to reduce a gap between the chip and a first housing wall of the heat dissipation housing. The first housing wall is a housing wall that is of the heat dissipation housing and that is opposite to the chip in position. The second housing wall is opposite to the first housing wall in position.

In an example, through elasticity applied to the circuit board by the elastic member, the gap between the chip and the first housing wall can be reduced, to make the chip and the first housing wall fit more closely to each other. Once the chip and the first housing wall fit more closely to each other, heat transfer between the chip and the first housing wall is accordingly faster, so that the heat dissipation housing can quickly absorb heat of the chip, and dissipate heat of a chip 3, to further improve heat dissipation effect of the electronic device.

In a possible implementation, the electronic device further includes a thermal interface material layer. The thermal interface material layer is filled in the gap between the chip and the first housing wall. The elastic member can also reduce a thickness of the thermal interface material layer filled in the gap.

In an example, although the thermal interface material layer is filled between the chip and the first housing wall that are of the electronic device, because the elastic member in a compressed state that is disposed on the circuit board and the second housing wall applies, to the circuit board, elastic force toward the chip, a large portion of the gap between the chip and the first housing wall has been eliminated. In this case, only the thin thermal interface material layer needs to be filled in the gap. For example, the thickness of the filled thermal interface material layer is only 0.05 millimeter to 0.07 millimeter, or even smaller.

It can be learned that, the elastic member in the compressed state that is installed between the circuit board and the second housing wall can eliminate the large portion of the gap between the chip and the first housing wall, and can greatly reduce the thickness of the thermal interface material layer filled between the chip and the first housing wall. Once the thickness of the thermal interface material layer is reduced, thermal resistance of the thermal interface material layer is also reduced. Once the thermal resistance of the thermal interface material layer is reduced, thermal conductivity of the thermal interface material layer can be improved, to further improve heat dissipation effect of the electronic device.

In a possible implementation, the circuit board includes a first sub-board and a second sub-board. The first sub-board and the second sub-board are electrically connected. The chip is located on a surface of the first sub-board. The elastic member is compressed between the first sub-board and the second housing wall. The second sub-board is fastened to a housing wall of the heat dissipation housing. An interface component of the electronic device is located on a surface of the second sub-board.

In an example, due to elastic force applied to the first sub-board by the elastic member, the large portion of the gap between the chip and the first housing wall can be eliminated, to make heat transfer between the chip and the first housing wall faster. Even if the thermal interface material layer is filled between the chip and the first housing wall, the thickness of the filled thermal interface material layer is small, for example, in a range of 0.05 millimeter to 0.07 millimeter, and the thermal resistance of the thermal interface material layer is small. In view of this, heat transfer between the chip and the first housing wall can still be faster, to enhance effect of dissipating heat of the chip.

For the interface component, because the interface component is located on the surface of the second sub-board and does not need to shake with the elastic member, a gap does not need to be reserved between the interface component and a mounting port through which the interface component is installed. In this way, sealing performance between the interface component and the mounting port can be ensured, to implement dustproof and waterproof effect.

According to another aspect, an electronic device is provided. The electronic device includes a heat dissipation housing, a circuit board, a chip, a thermal interface material layer, and an elastic member. The circuit board, the chip, the thermal interface material layer, and the elastic member are all located in a chamber formed by the heat dissipation housing. The chip is located on a surface of the circuit board. The elastic member is compressed between the circuit board and a second housing wall of the heat dissipation housing, to reduce a gap between the chip and a first housing wall of the heat dissipation housing. The gap is filled with the thermal interface material layer. The first housing wall is a housing wall that is of the heat dissipation housing and that is opposite to the chip in position. The second housing wall is opposite to the first housing wall in position.

It can be learned that, the elastic member in the compressed state that is installed between the circuit board and the second housing wall can eliminate a large portion of the gap between the chip and the first housing wall, and can greatly reduce the thickness of the thermal interface material layer filled between the chip and the first housing wall. Once the thickness of the thermal interface material layer is reduced, thermal resistance of the thermal interface material layer is also reduced. Once the thermal resistance of the thermal interface material layer is reduced, thermal conductivity of the thermal interface material layer can be improved, to further improve heat dissipation effect of the electronic device.

### BRIEF DESCRIPTION OF DRAWINGS

FIG. 1 is a schematic diagram of a structure in which an elastic member is located in a heat dissipation housing according to this application;
FIG. 2 is a schematic diagram of a structure of an electronic device according to this application;
FIG. 3 is a schematic diagram of a structure of an electronic device according to this application;
FIG. 4 is a schematic diagram of a structure of an electronic device according to this application;
FIG. 5 is a schematic diagram of a structure of a heat pipe of an electronic device according to this application;
FIG. 6 is a schematic diagram of a structure of an electronic device according to this application;
FIG. 7 is a schematic diagram of a structure of an electronic device according to this application;
FIG. 8 is a schematic diagram of a structure of an electronic device according to this application;
FIG. 9 is a schematic diagram of a structure of an electronic device according to this application;
FIG. 10 is a schematic diagram of a structure of an electronic device according to this application;
FIG. 11 is a schematic diagram of a structure of an electronic device according to this application;
FIG. 12 is a schematic diagram of a structure of an electronic device according to this application;
FIG. 13 is a schematic diagram of a structure of an electronic device according to this application;
FIG. 14 is a schematic diagram of a structure of an electronic device according to this application; and
FIG. 15 is a schematic diagram of a structure of an electronic device according to this application.

### Reference numerals:

1. heat dissipation housing; 101. chamber; 11. first housing wall; 12. opening; 13. second housing wall;
14. upper cover; 15. bottom; 16. housing heat dissipation fin;
2. circuit board; 21. first sub-board; 22. second sub-board; 3. chip;
4. thermal interface material layer; 5. heat conducting member;
6. elastic member; 61. spring; 62. heat pipe; 621. first pipe section; 622, second pipe section; 623. third pipe section;
7. heat dissipation apparatus; 71. heat dissipation base; 72. mounting plate; 73. vapor chamber; 74. heat dissipation fin;
8. fastener; 9. seal; 10. interface component.

### DESCRIPTION OF EMBODIMENTS

An embodiment of this application provides an electronic device. The electronic device may be a device in the computer field, a device in the vehicle field, or the like. A specific field to which the electronic device relates is not limited in this embodiment. The electronic device may be applied to any field in which heat needs to be dissipated from a chip and a dustproof and waterproof heat dissipation housing further needs to be provided. For example, the electronic device may be an in-vehicle module used outdoors.

In this embodiment, a dustproof and waterproof level of a heat dissipation housing of the electronic device is IP54 or higher. From a dustproof perspective, the heat dissipation housing can completely prevent foreign objects from entering the electronic device. Ingress of dust is not entirely prevented, but dust cannot enter in sufficient amount to interfere with normal operation of the electronic device. From a waterproof perspective, the heat dissipation housing can prevent water splashing from all directions from intruding into the electronic device and causing damage.

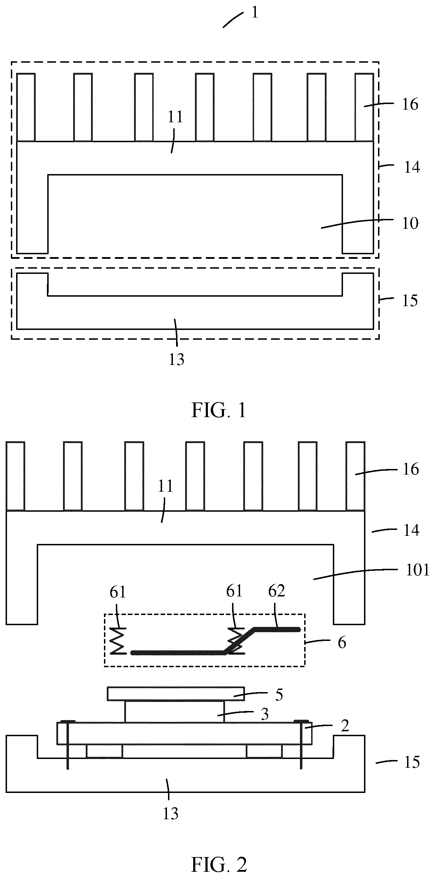

As shown in FIG. 1, a heat dissipation housing 1 of the electronic device includes a plurality of housing walls, and the plurality of housing walls may be enclosed into a chamber 101. For example, the heat dissipation housing 1 is a hexahedron box body, and includes six housing walls, and the six housing walls may be enclosed into the chamber 101. A component of the electronic device may be located in the heat dissipation housing 1. Because the heat dissipation housing 1 can play a role in heat dissipation, waterproofing, dust prevention, and the like for the component in the heat dissipation housing 1, with a dustproof and waterproof level of IP54 or higher, the heat dissipation housing 1 can effectively prevent dust and water from entering the chamber 101 and affecting normal operation of the component of the electronic device.

Still refer to FIG. 1. The heat dissipation housing 1 may include an upper cover 14 and a bottom 15. The upper cover 14 covers the bottom 15 to form the heat dissipation housing 1 having the chamber 101.

For example, as shown in FIG. 1, the upper cover 14 of the heat dissipation housing 1 may be a bottomless housing-shaped structure, and the bottom 15 may be a coverless housing-shaped structure. Sizes of the upper cover 14 and the bottom 15 are matched. For example, a length and a width of the upper cover 14 respectively match a length and a width of the bottom 15, so that the upper cover 14 covers the bottom 15 to form the housing having the chamber.

For another example, the upper cover 14 of the heat dissipation housing 1 may alternatively be a plate-shaped structure, the bottom 15 may be a coverless housing-shaped structure, and the upper cover 14 covers the bottom 15 to form the heat dissipation housing 1. Alternatively, the upper cover 14 of the heat dissipation housing 1 is a bottomless housing-shaped structure without a bottom, the bottom 15 is a plate-shaped structure, and the upper cover 14 covers the bottom 15 to form the heat dissipation housing 1. A specific forming manner of the heat dissipation housing 1 is not limited in this embodiment, provided that the heat dissipation housing 1 has a chamber configured to accommodate the component of the electronic device and has good sealing performance.

Because the heat dissipation housing 1 further has a heat dissipation function, the heat dissipation housing 1 may be die-cast from metal, for example, metal aluminum, aluminum alloy, metal copper, or copper alloy.

To increase a total heat dissipation area of the heat dissipation housing 1, as shown in FIG. 1, housing heat dissipation fins 16 may be disposed on an outer surface of the heat dissipation housing 1. For example, the housing heat dissipation fins 16 are disposed on an outer surface of the upper cover 14. For another example, the housing heat dissipation fins 16 are disposed on both an outer surface of the upper cover 14 and an outer surface of the bottom 15. This is not limited in this embodiment. A person skilled in the art may flexibly select a specific position, on the outer surface of the heat dissipation housing 1, of the housing heat dissipation fin 16 based on an actual situation.

In an example, the heat dissipation housing 1 is processed in a die casting manner. Correspondingly, the housing heat dissipation fin 16 may also be processed in the die casting manner. The housing heat dissipation fin 16 may alternatively be processed in a welding manner. Heat dissipation fins are processed in a welding manner, so that the housing heat dissipation fins 16 are densely distributed on the outer surface of the heat dissipation housing 1. Denser housing heat dissipation fins 16 indicate a larger total heat dissipation area of the heat dissipation housing 1 and better effect of dissipating heat of a chip 3. A skilled person may flexibly select a specific processing manner for the housing heat dissipation fin 16 on the outer surface of the heat dissipation housing 1 based on an actual situation. This is not limited in this embodiment.

For ease of installing the component of the electronic device in the heat dissipation housing 1, correspondingly, the upper cover 14 and the bottom 15 of the heat dissipation housing 1 are detachably installed. For example, a housing wall of the upper cover 14 and a housing wall of the bottom 15 are assembled by using a screw and the like. Installation manners of the upper cover 14 and the bottom 15 are not limited in this embodiment. A skilled person may flexibly select the installation manner based on an actual situation.

The electronic device in this embodiment further includes a circuit board 2 and the chip 3. The circuit board 2 is located in the heat dissipation housing 1. For example, the circuit board 2 may be installed on an inner surface of the housing wall of the upper cover 14, or the circuit board 2 may be installed on an inner surface of the housing wall of the bottom 15. Then, the chip 3 and other components of the electronic device are installed on the circuit board 2. Finally, the upper cover 14 is installed on the bottom 15.

For ease of description, a housing wall opposite to the chip 3 may be referred to as a first housing wall 11. In other words, a housing wall opposite to a surface that is of the chip 3 and that is away from the circuit board 2 is referred to as the first housing wall 11. A housing wall opposite to the circuit board 2 is referred to as a second housing wall 13. In other words, a housing wall opposite to a surface that is of the circuit board 2 and that is away from the chip 3 is referred to as the second housing wall 13. Positions of the first housing wall 11 and the second housing wall 13 are opposite. As shown in FIG. 1, the first housing wall 11 may be a top wall of the upper cover 14, and the second housing wall 13 may be a bottom wall of the bottom 15.

In an example, the chip 3 may be electrically connected to another component of the electronic device by using a flat cable on the circuit board 2. Correspondingly, the chip 3 is located on the circuit board 2. For example, the chip 3 is tin soldered on the surface of the circuit board 2. For example, a top (top) surface or a bottom (bottom) surface of the circuit board 2 has a chip reserved position, and the chip 3 may be tin soldered at the chip reserved position. When the chip 3 works, heat is generated. The heat dissipation housing 1 may dissipate the heat of the chip 3. Correspondingly, the heat of the chip 3 may be transferred to a housing wall of the heat dissipation housing 1, and is dissipated through the housing wall of the heat dissipation housing 1. A specific path for dissipating the heat is described in detail in the following description of a structure of the electronic device.

In an application scenario, the electronic device may include a plurality of chips 3. The chip 3 in this embodiment may be any chip on the surface of the circuit board 2, or may be a main chip on the surface of the circuit board 2. The main chip is a chip whose power consumption accounts for 50% of total power consumption.

Specific structures of several electronic devices provided in this embodiment are described in detail below.

For schematic diagrams of a structure of an electronic device, refer to FIG. 2 to FIG. 6.

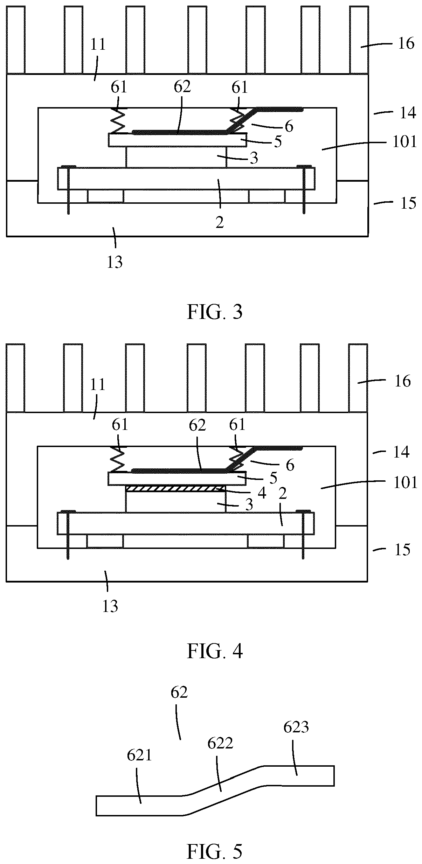

FIG. 2 is a schematic diagram of an exploded structure of the electronic device. The electronic device not only includes the heat dissipation housing 1, the circuit board 2, and the chip 3, but also includes a heat conducting member 5 and an elastic member 6. FIG. 3 is a schematic diagram of a structure of an assembled electronic device. The heat conducting member 5 is located on a surface that is of the chip 3 and that is away from the circuit board 2. The elastic member 6 is compressed between the heat conducting member 5 and the first housing wall 11 of the heat dissipation housing 1. The elastic member 6 has not only compression elasticity but also a heat transfer property. In this way, heat generated by the chip 3 may be transferred to the heat conducting member 5, transferred by the heat conducting member 5 to the elastic member 6, and then transferred by the elastic member 6 to the first housing wall 11, to dissipate the heat outward by the first housing wall 11.

As shown in FIG. 2, the circuit board 2 may be fastened in the chamber 101 of the heat dissipation housing 1. For example, as shown in FIG. 2, the circuit board 2 is fastened to the bottom 15 of the heat dissipation housing 1 by using a screw. The circuit board 2 may alternatively be fastened to the upper cover 14 of the heat dissipation housing 1 by using a screw. An installation position and an installation manner of the circuit board 2 in the chamber 101 of the heat dissipation housing 1 are not limited in this embodiment, provided that the circuit board 2 can be securely fastened in the chamber 101.

The circuit board 2 can be fastened in the chamber 101 to provide supporting force for compressive elastic force of the elastic member 6.

As shown in FIG. 3, the heat conducting member 5 is located on the surface that is of the chip 3 and that is away from the circuit board 2, and the heat conducting member 5 is configured to absorb heat of the chip 3, and transfer the absorbed heat to the heat dissipation housing 1. The heat conducting member 5 matches the chip 3 in shape and size respectively. For example, the heat conducting member 5 is a plate-like structure, and the size of the heat conducting member 5 is equivalent to the size of the chip 3, or an area of the heat conducting member 5 is slightly larger than an area of the chip 3. The heat conducting member 5 covers the surface of the chip 3 to absorb heat at each position of the chip 3. The heat conducting member 5 may be a copper plate, a vapor chamber, or the like. Materials of the heat conducting member are not limited in this embodiment, provided that the heat conducting member 5 can quickly absorb the heat of the chip 3.

To reduce a gap between the chip 3 and the heat conducting member 5, so as to increase a contact area between the heat conducting member 5 and the chip 3, and accelerate heat absorption for the chip 3 by the heat conducting member 5, correspondingly, as shown in FIG. 3, the elastic member 6 is compressed between the heat conducting member 5 and the first housing wall 11 of the heat dissipation housing 1. The first housing wall 11 is a housing wall that is of the heat dissipation housing 1 and that is opposite to the heat conducting member 5 in position. The elastic member 6 is compressed between the heat conducting member 5 and the first housing wall 11, so that the chip 3 and the heat conducting member 5 can be squeezed against each other, to reduce or even eliminate the gap between the chip 3 and the heat conducting member 5. That the chip 3 and the heat conducting member 5 fit more closely to each other indicates better heat transfer effect between the chip 3 and the heat conducting member 5.

The elastic member 6 has not only elasticity but also the heat transfer property, and is compressed between the heat conducting member 5 and the first housing wall 11. This can reduce the gap between the chip 3 and the heat conducting member 5 to transfer, to the heat dissipation housing 1, the heat absorbed by the heat conducting member 5 from the chip 3, and dissipate the heat outward by the heat dissipation housing 1. A specific structure of the elastic member 6 is described in detail below.

It can be learned that, the elastic member 6 compressed between the first housing wall 11 and the heat conducting member 5 can press the chip 3 against a surface of the heat conducting member 5, to make the chip 3 and the heat conducting member 5 fit more closely to each other, make heat transfer faster between the chip 3, the heat conducting member 5, and the heat dissipation housing 1, and improve heat dissipation effect of the electronic device.

To further reduce the gap between the chip 3 and the heat conducting member 5, correspondingly, as shown in FIG. 4, a thermal interface material layer 4 is further filled between the chip 3 and the heat conducting member 5. The thermal interface material layer 4 is a flexible material and has specific heat conductivity. For example, the thermal interface material layer 4 may be silica gel, silicone grease, gel, or the like. A specific material of the thermal interface material layer 4 is not limited in this embodiment, provided that the thermal interface material layer 4 can reduce the gap and implement heat conduction effect.

Although the thermal interface material layer 4 is filled between the chip 3 and the heat conducting member 5 that are of the electronic device, because the elastic member 6 compressed between the heat conducting member 5 and the first housing wall 11 applies pressing force to the heat conducting member 5, a large portion of the gap between the chip 3 and the heat conducting member 5 has been eliminated. In this case, only the thin thermal interface material layer 4 needs to be filled in the gap. For example, a thickness of the filled thermal interface material layer 4 is only 0.05 millimeter to 0.07 millimeter, or even smaller.

In addition, because the thin thermal interface material layer 4 filled between the chip 3 and the heat conducting member 5 has compression and deformation characteristics, and the elastic member 6 applies pressing force to the heat conducting member 5, the thickness of the thermal interface material layer 4 can be further reduced, so that the thermal interface material layer 4 is further thinned. For example, the thermal interface material layer 4 that is made of the silica gel and with a thickness of 0.07 millimeter is selected and filled between the chip 3 and the heat conducting member 5. The thermal interface material layer 4 is compressed by 0.02 millimeter in thickness again under a pressing action of the elastic member 6. In this case, the thickness of the thermal interface material layer 4 finally filled between the chip 3 and the heat conducting member 5 is 0.05 millimeter.

It can be learned that, the elastic member 6 compressed between the heat conducting member 5 and the first housing wall 11 can eliminate the large portion of the gap between the chip 3 and the heat conducting member 5, and can greatly reduce the thickness of the thermal interface material layer 4 filled between the chip 3 and the heat conducting member 5. Once the thickness of the thermal interface material layer 4 is reduced, thermal resistance of the thermal interface material layer 4 is also reduced. Once the thermal resistance of the thermal interface material layer 4 is reduced, thermal conductivity of the thermal interface material layer 4 can be improved, to further improve the heat dissipation effect of the electronic device.

For example, when the elastic member 6 is not compressed between the heat conducting member 5 and the first housing wall 11, the thermal interface material layer 4 with a thickness of 1 millimeter to 1.5 millimeter needs to be disposed between the chip 3 and the heat conducting member 5. When the elastic member 6 is compressed between the heat conducting member 5 and the first housing wall 11, the thermal interface material layer 4 with a thickness of only 0.05 millimeter to 0.07 millimeter needs to be disposed between the chip 3 and the heat conducting member 5. It can be learned that, the thickness of the thermal interface material layer 4 in the former case is significantly greater than that of the thermal interface material layer 4 in the latter case. In this case, the thermal resistance of the thermal interface material layer 4 in the former case is also greater than that of the thermal interface material layer 4 in the latter case. Further, heat transfer performance of the thermal interface material layer 4 in the latter case is higher than that of the thermal interface material layer 4 in the former case.

As described above, a heat dissipation path for the electronic device is as follows: The chip 3 generates the heat. The heat conducting member 5 located on the surface of the chip 3 absorbs the heat and transfers the heat to the elastic member 6. Then, the elastic member 6 transfers the heat to the heat dissipation housing 1, and finally the heat dissipation housing 1 dissipates the heat outward.

It can be learned that, the elastic member 6 not only has a function of pressing the heat conducting member 5 against the surface of the chip 3, but also needs to have a heat transfer function. The following describes several elastic members 6 that have the heat transfer property.

A possible structure of the elastic member 6 may be as follows: As shown in FIG. 2, the elastic member 6 includes springs 61 and a heat pipe 62. As shown in FIG. 4, the spring 61 is compressed between the heat conducting member 5 and the first housing wall 11, to reduce the gap between the chip 3 and the heat conducting member 5. The heat pipe 62 is connected between the heat conducting member 5 and the first housing wall 11 to transfer, to the heat dissipation housing 1, the heat absorbed by the heat conducting member 5 from the chip 3. In addition, the heat pipe 62 has elasticity and is compressed between the heat conducting member 5 and the first housing wall 11.

The heat pipe 62 is a copper pipe internally filled with a coolant (which may also be referred to as a heat dissipation liquid).

The heat pipe 62 further has the elasticity, and is also compressed between the heat conducting member 5 and the first housing wall 11, so that the heat pipe 62 can perform a telescopic movement with the spring 61. In this way, when the spring 61 applies, to the heat conducting member 5, elastic force toward the chip 3, the heat pipe 62 does not apply acting force in an opposite direction to the heat conducting member 5, so that reduction of the gap between the heat conducting member 5 and the chip 3 is not affected.

To implement the elasticity of the heat pipe 62, correspondingly, as shown in FIG. 5, the heat pipe 62 may include three sections: a first pipe section 621, a second pipe section 622, and a third pipe section 623. The first pipe section 621 is attached to a surface that is of the heat conducting member 5 and that is away from the chip 3. The third pipe section 623 is attached to an inner surface of the first housing wall 11. The second pipe section 622 is obliquely connected between the first pipe section 621 and the second pipe section 622.

For example, an outer surface of a pipe wall of the first pipe section 621 may be welded to the surface that is of the heat conducting member 5 and that is away from the chip 3, and an outer surface of a pipe wall of the third pipe section 623 may be welded to the inner surface of the first housing wall 11 of the heat dissipation housing 1. The second pipe section 622 is obliquely disposed between the heat conducting member 5 and the first housing wall 11, to implement the elasticity of the heat pipe 62 without interfering with the telescopic movement of the spring 61.

The second pipe section 622 is obliquely connected between the first pipe section 621 and the third pipe section 623. For example, as shown in FIG. 5, the second pipe section 622 is inclined to the right relative to the first pipe section 621. For another example, the second pipe section 622 may also be inclined to the left relative to the first pipe section 621. Whether the second pipe section 622 is inclined to the right or left relative to the first pipe section 621 is not limited in this embodiment. An angle of inclination of the second pipe section 622 relative to the first pipe section 621 is not limited in this embodiment. A skilled person may flexibly select the angle of inclination based on an actual situation.

Because the second pipe section 622 is inclined relative to the first pipe section 621 and the third pipe section 623, and the heat pipe 62 is made of metal and has ductility, a connecting part between the first pipe section 621 and the second pipe section 622 can be elastic and deformable, and a connecting part between the second pipe section 622 and the third pipe section 623 can be elastic and deformable.

It can be learned that, the elastic member 6 provides telescopic elasticity by using the spring 61 and provides a heat transfer property by using the heat pipe 62.

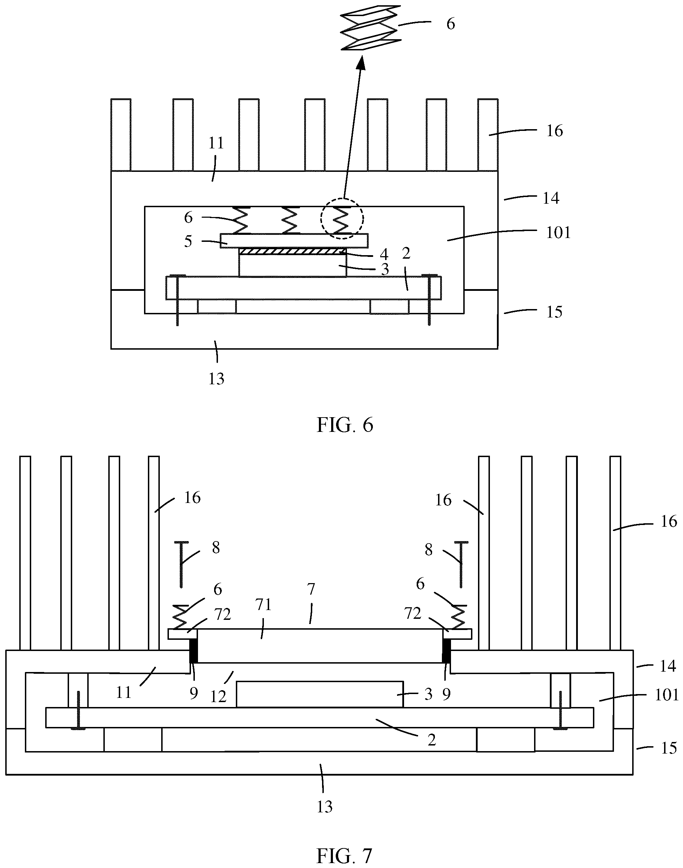

Another possible structure of the elastic member 6 may be as follows: As shown in FIG. 6, the elastic member 6 is a bent heat conduction sheet, for example, may be a bent metal sheet, a bent copper sheet, or a bent vapor chamber. The elastic member 6 can be compressed between the heat conducting member 5 and the first housing wall 11 and can transfer heat between the heat conducting member 5 and the first housing wall 11.

In an example, there may be a plurality of elastic members 6, and a plurality of bent heat conduction sheets are compressed between the heat conducting member 5 and the first housing wall 11. The plurality of bent heat conduction sheets may be evenly compressed between the heat conducting member 5 and the first housing wall 11. Alternatively, the bent heat conduction sheets may be densely arranged at a position with high heat, and may be sparsely arranged at a position with low heat. A skilled person can flexibly select an arrangement manner based on an actual situation.

In the electronic device shown in FIG. 2 to FIG. 5, the elastic member 6 is compressed between the heat conducting member 5 and the first housing wall 11, so that the large portion of the gap between the chip 3 and the heat conducting member 5 can be eliminated, and the chip 3 and the heat conducting member 5 can fit more closely to each other. Once the chip 3 and the heat conducting member 5 fit more closely to each other, heat transfer between the chip 3 and the heat conducting member 5 is accordingly faster, so that the heat conducting member 5 can quickly absorb the heat of the chip 3 and transfer the absorbed heat to the heat dissipation housing 1 by using the elastic member 6 having the heat transfer property, to further improve the heat dissipation effect of the electronic device.

For a schematic diagram of a structure of another electronic device, refer to FIG. 4.

The electronic device not only includes the heat dissipation housing 1, the circuit board 2, and the chip 3, but also includes the thermal interface material layer 4, the heat conducting member 5, and the elastic member 6. The heat conducting member 5 is located on a surface that is of the chip 3 and that is away from the circuit board 2. The thermal interface material layer 4 is located on a surface that is of the heat conducting member 5 and that is away from the chip 3. The elastic member 6 having the heat transfer property is compressed between the heat conducting member 5 and the first housing wall 11.

For descriptions of the electronic device having such a structure, refer to the foregoing descriptions of FIG. 4 and FIG. 6. Details are not described one by one herein again.

In the electronic device shown in FIG. 4, the elastic member 6 is compressed between the heat conducting member 5 and the first housing wall 11, so that a large portion of the gap between the chip 3 and the heat conducting member 5 can be eliminated, and a thickness of the thermal interface material layer 4 filled between the chip 3 and the heat conducting member 5 can be reduced. Once the thickness of the thermal interface material layer 4 is reduced, thermal resistance of the thermal interface material layer 4 is also reduced. Once the thermal resistance of the thermal interface material layer 4 is reduced, heat transfer from the chip 3 to the thermal interface material layer 4 to the heat conducting member 5 can be faster, so that the heat conducting member 5 can quickly absorb heat of the chip 3, and sequentially transfer the absorbed heat to the heat interface material layer 4, the elastic member 6 having a heat transfer property, and the heat dissipation housing 1, to further improve heat dissipation effect of the electronic device.

For a schematic diagram of a structure of another electronic device, refer to FIG. 7 to FIG. 12.

FIG. 7 is a schematic diagram of a structure of an electronic device before assembly. The electronic device not only includes the heat dissipation housing 1, the circuit board 2, and the chip 3, but also includes the elastic members 6 and the heat dissipation apparatus 7. The circuit board 2 is located in the chamber 101 formed by a housing wall of the heat dissipation housing 1. For example, as shown in FIG. 7, the circuit board 2 is fastened to the upper cover 14 of the heat dissipation housing 1 by using a screw. Certainly, the circuit board 2 may alternatively be fastened to the bottom 15 of the heat dissipation housing 1 by using a screw. An installation position and an installation manner of the circuit board 2 in the chamber 101 of the heat dissipation housing 1 are not limited in this embodiment, provided that the circuit board 2 can be securely fastened in the chamber 101. The chip 3 is located on a surface of the circuit board 2, for example, may be tin soldered at the surface of the circuit board 2.

The heat dissipation apparatus 7 is configured to dissipate heat of the chip 3. To accelerate heat dissipation for the chip 3, the heat dissipation apparatus 7 may be made of metal with a high thermal conductivity coefficient, for example, may be made of copper.

As shown in FIG. 7, the heat dissipation apparatus 7 may include a heat dissipation base 71 and mounting plates 72. The heat dissipation base 71 may have a plate-shaped structure and have a specific thickness. The mounting plate 72 may be located on a side wall of the heat dissipation base 71, and a bottom of the mounting plate 72 is higher than a bottom of the heat dissipation base 71. The heat dissipation base 71 is configured to contact the chip 3. The mounting plate 72 is configured to implement detachable installation of the heat dissipation apparatus 7 and the heat dissipation housing 1. A position relationship and an installation relationship between the heat dissipation apparatus 7 and the heat dissipation housing 1 may be as follows:

As shown in FIG. 7, the first housing wall 11 of the heat dissipation housing 1 has an opening 12 at a position corresponding to the chip 3. The opening 12 matches the chip 3 in size. For example, an area of the opening 12 is greater than an area of the chip 3. For example, the first housing wall 11 may be provided with the opening 12 at a position corresponding to the chip 3. The opening 12 may be a rectangular window, so that the heat dissipation base 71 of the heat dissipation apparatus 7 can be seated in the opening 12.

The heat dissipation base 71 matches the opening 12 in size. For example, an area of the heat dissipation base 71 is slightly greater than or equal to the area of the opening 12, so that the heat dissipation base 71 can be disposed in the opening 12. The heat dissipation base 71 is located on a surface that is of the chip 3 and that is away from the circuit board 2. The mounting plate 72 is located on an outer surface of the first housing wall 11.

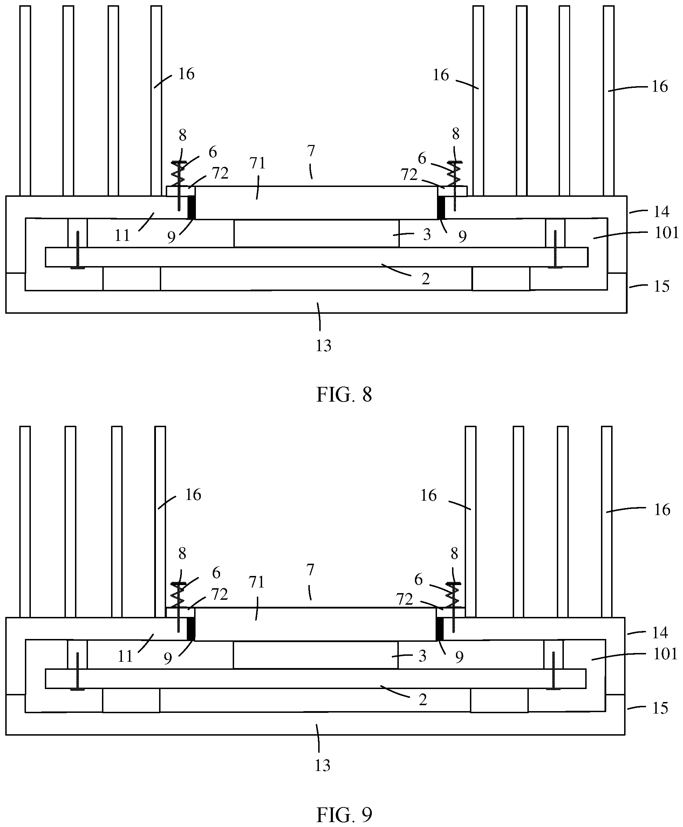

In this way, the chip 3 is opposite to the opening 12 in position, and the area of the opening 12 is greater than the area of the chip 3. As shown in FIG. 8, the bottom of the heat dissipation base 71 can be seated in the opening 12 and can be in contact with the chip 3. The mounting plate 72 is mounted on the outer surface of the first housing wall 11.

To reduce a gap between the heat dissipation apparatus 7 and the chip 3, correspondingly, as shown in FIG. 8, the elastic member 6 is located on a surface that is of the mounting plate 72 and that is away from the first housing wall 11. Both the elastic member 6 and the mounting plate 72 are fastened to the first housing wall 11 by using a fastener 8. The elastic member 6 is compressed between the fastener 8 and the mounting plate 72, to reduce a gap between the chip 3 and the heat dissipation base 71.

The fastener 8 may be any structure with a transverse plate on the top, and the transverse plate on the top of the fastener 8 serves to compress the elastic member 6. For example, the fastener 8 may be a screw, and a nut of the screw may be used as the transverse plate on the top of the fastener 8.

The elastic member 6 may be any structure having compression elasticity, for example, may be a spring.

In this way, the elastic member 6 is located on an outer surface of the mounting plate 72, and the fastener 8 can successively pass through the elastic member 6, the mounting plate 72, and the first housing wall 11, to implement detachable installation between the heat dissipation apparatus 7 and the heat dissipation housing 1. The elastic member 6 is compressed between the transverse plate on the top of the fastener 8 and the mounting plate 72, for example, the elastic member 6 is compressed between a nut of a screw and the mounting plate 72.

In the electronic device shown in FIG. 8, the elastic member 6 is compressed between the top of the fastener 8 and the mounting plate 72, so that a large portion of the gap between the chip 3 and the heat dissipation base 71 can be eliminated, and the chip 3 and the heat dissipation base 71 can fit more closely to each other. Once the chip 3 and the heat dissipation base 71 fit more closely to each other, heat transfer between the chip 3 and the heat dissipation base 71 is accordingly faster, so that the heat dissipation base 71 can quickly absorb heat of the chip 3 and dissipate the heat of the chip 3, to further improve heat dissipation effect of the electronic device.

In addition, in terms of a path for dissipating the heat of the chip 3, as shown in FIG. 8, because the bottom of the mounting plate 72 is closely attached to the outer surface of the first housing wall 11, the heat dissipation apparatus 7 and the heat dissipation housing 1 are thermally connected, so that the heat absorbed by the heat dissipation base 71 from the chip 3 can also be transferred to the heat dissipation housing 1, to dissipate the heat of the chip 3 by heat dissipation housing 1. It can be learned that, in the electronic device shown in FIG. 8, one portion of heat generated by the chip 3 is absorbed by the heat dissipation apparatus 7 and is dissipated outward by the heat dissipation apparatus 7; and the another portion of heat is transferred to the heat dissipation housing 1 by the heat dissipation apparatus 7 and is dissipated outward by the heat dissipation housing 1. It can be learned that, the heat generated by the chip 3 can be jointly dissipated outward by the heat dissipation apparatus 7 and the heat dissipation housing 1.

To further make heat transfer faster between the heat dissipation apparatus 7 and the heat dissipation housing 1, correspondingly, as shown in FIG. 9, an end that is of the mounting plate 72 and that is away from the heat dissipation base 71 is in contact with the housing heat dissipation fin 16 of the heat dissipation housing 1.

In this way, the bottom of the mounting plate 72 is in contact with the first housing wall 11, and the end of the mounting plate 72 is in contact with the housing heat dissipation fin 16, so that a contact area between the mounting plate 72 and the heat dissipation housing 1 can be increased, to make heat transfer faster between the heat dissipation apparatus 7 and the heat dissipation housing 1, and enhance effect of dissipating the heat of the chip 3.

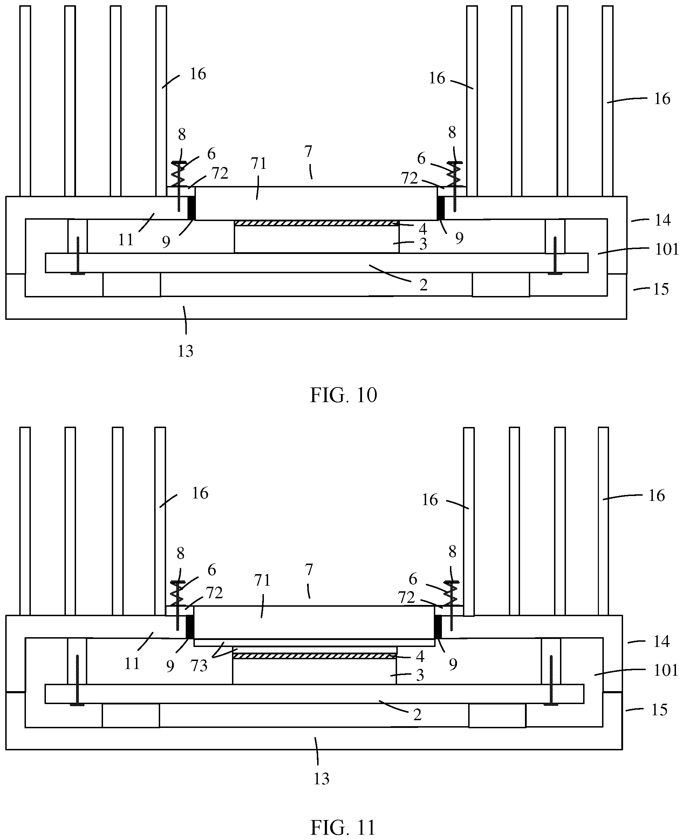

To further reduce the gap between the chip 3 and the heat dissipation base 71, correspondingly, as shown in FIG. 10, the thermal interface material layer 4 is further filled between the chip 3 and the heat dissipation base 71. The thermal interface material layer 4 is a flexible material and has thermal conductivity. For example, the thermal interface material layer 4 may be silica gel, silicone grease, gel, or the like. A specific material of the thermal interface material layer 4 is not limited in this embodiment, provided that the thermal interface material layer 4 can reduce the gap and implement heat conduction effect.

Although the thermal interface material layer 4 is filled between the chip 3 and the heat dissipation base 71 that are of the electronic device, because the elastic member 6 in a compressed state that is disposed on an outer surface of the mounting plate 71 applies pressing force to the heat dissipation base 71, the large portion of the gap between the chip 3 and the heat dissipation base 71 has been eliminated. In this case, only the thin thermal interface material layer 4 needs to be filled in the gap. For example, a thickness of the filled thermal interface material layer 4 is only 0.05 millimeter to 0.07 millimeter, or even smaller.

In addition, because the thin thermal interface material layer 4 filled between the chip 3 and the heat dissipation base 71 has compression and deformation characteristics, and the elastic member 6 applies pressing force to the heat dissipation base 71, the thickness of the thermal interface material layer 4 can be further reduced, so that the thermal interface material layer 4 is further thinned. For example, the thermal interface material layer 4 that is made of the silica gel and with a thickness of 0.07 millimeter is selected and filled between the chip 3 and the heat dissipation base 71. The thermal interface material layer 4 is compressed by 0.02 millimeter in thickness again under a pressing action of the elastic member 6. In this case, the thickness of the thermal interface material layer 4 finally filled between the chip 3 and the heat dissipation base 71 is 0.05 millimeter.

It can be learned that, the elastic member 6 in the compressed state can eliminate the large portion of the gap between the chip 3 and the heat dissipation base 71, and can greatly reduce the thickness of the thermal interface material layer 4 filled between the chip 3 and the heat dissipation base 71. Once the thickness of the thermal interface material layer 4 is reduced, thermal resistance of the thermal interface material layer 4 is also reduced. Once the thermal resistance of the thermal interface material layer 4 is reduced, thermal conductivity of the thermal interface material layer 4 can be improved, to further improve the heat dissipation effect of the electronic device.

For example, in a solution in which the elastic member 6 is not disposed, the thermal interface material layer 4 with a thickness of 1 millimeter to 1.5 millimeter needs to be disposed between the chip 3 and the heat dissipation base 71. In a solution in which the elastic member 6 in the compressed state is disposed on the outer surface of the mounting plate 72, the thermal interface material layer 4 with a thickness of only 0.05 millimeter to 0.07 millimeter needs to be disposed between the chip 3 and the heat dissipation base 71. It can be learned that, the thickness of the thermal interface material layer 4 in the former case is significantly greater than that of the thermal interface material layer 4 in the latter case. In this case, the thermal resistance of the thermal interface material layer 4 in the former case is also greater than that of the thermal interface material layer 4 in the latter case. Further, heat transfer performance of the thermal interface material layer 4 in the latter case is higher than that of the thermal interface material layer 4 in the former case.

In the electronic device shown in FIG. 10, the elastic member 6 in the compressed state is disposed on the outer surface of the mounting plate 72, so that a large portion of the gap between the chip 3 and the heat dissipation base 71 can be eliminated, and the thickness of the thermal interface material layer 4 filled between the chip 3 and the heat dissipation base 71 can be reduced. Once the thickness of the thermal interface material layer 4 is reduced, thermal resistance of the thermal interface material layer 4 is also reduced. Once the thermal resistance of the thermal interface material layer 4 is reduced, heat transfer from the chip 3 to the thermal interface material layer 4 to the heat dissipation base 71 can be faster, so that the heat dissipation base 71 can quickly absorb heat of the chip 3. In addition, the heat dissipation base 71 can transfer the absorbed heat to the heat dissipation housing 1, to further improve heat dissipation effect of the electronic device.

To further make heat transfer faster between the chip 3 and the heat dissipation apparatus 7, correspondingly, as shown in FIG. 11, a vapor chamber 73 is disposed on a surface that is of the heat dissipation base 71 and that is close to the chip 3.

The vapor chamber 73 matches the chip 3. For example, a shape of the vapor chamber 73 matches a shape of the chip 3, and an area of the vapor chamber 73 matches the area of the chip 3.

In this way, in one solution, the heat dissipation base 71 passes through the opening 12 and is located on the surface of the chip 3. The vapor chamber 73 at the bottom of the heat dissipation base 71 is in contact with the chip 3. The elastic member 6 in the compressed state that is located on the outer surface of the mounting plate 72 presses the heat dissipation base 71 against a surface that is of the chip 3 and that is opposite to the circuit board 2, so that the vapor chamber 73 is closely attached to the chip 3, to make heat transfer faster between the chip 3 and the vapor chamber 73.

In another solution, the heat dissipation base 71 passes through the opening 12 and is located on the surface of the chip 3. The vapor chamber 73 at the bottom of the heat dissipation base 71 is in contact with the thermal interface material layer 4, and the thermal interface material layer 4 is in contact with the chip 3. The elastic member 6 in the compressed state that is located on the outer surface of the mounting plate 72 presses the heat dissipation base 71 against a surface that is of the chip 3 and that is opposite to the circuit board 2, to reduce a gap between the vapor chamber 73 and the chip 3. The thin thermal interface material layer 4 is filled in the gap. For example, the thickness of the thermal interface material layer 4 is about 0.05 millimeter, to make heat transfer faster between the chip 3 and the vapor chamber 73.

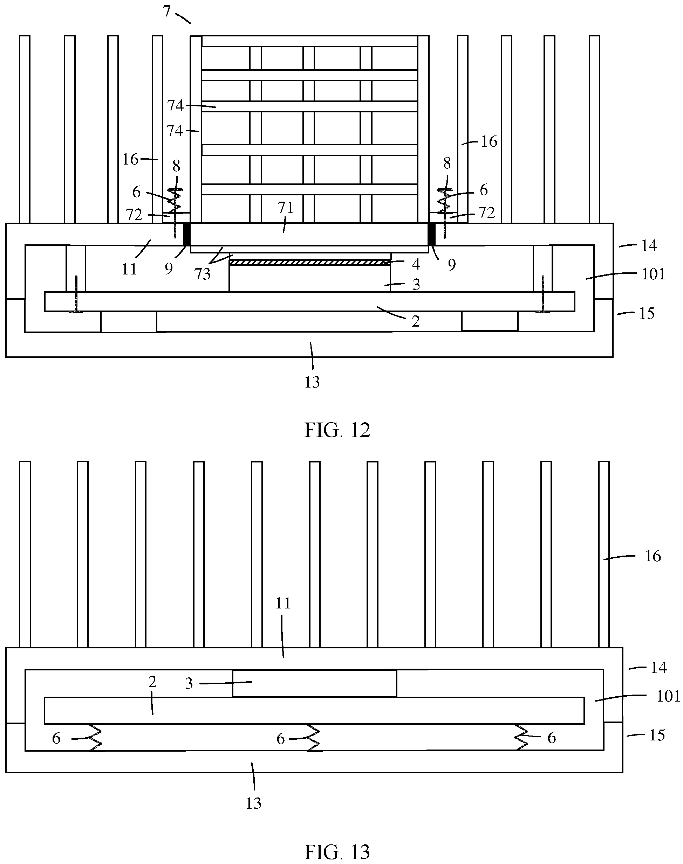

To improve a heat dissipation capability of the heat dissipation apparatus 7, correspondingly, as shown in FIG. 12, the heat dissipation apparatus 7 further includes heat dissipation fins 74. The heat dissipation fin 74 is located on a surface that is of the heat dissipation base 71 and that is away from the chip 3.

The heat dissipation fin 74 may increase a total heat dissipation area of the heat dissipation base 71, to accelerate heat dissipation for the chip 3.

As shown in FIG. 12, the heat dissipation fins 74 may include vertical heat dissipation fins perpendicular to the heat dissipation base 71. To increase a quantity of heat dissipation fins 74, the heat dissipation fins 74 may further include transverse heat dissipation fins perpendicular to the vertical heat dissipation fins. A skilled person may flexibly select arrangement of the heat dissipation fins 74 on the outer surface of the heat dissipation base 71 based on an actual situation.

In an example, the heat dissipation fins 74 may be installed in a plurality of manners, for example, may be mounted on the outer surface of the heat dissipation base 71 in a welding manner. The heat dissipation fins 74 are processed in a welding manner, so that a quantity of the heat dissipation fins 74 is increased and the heat dissipation fins 74 are dense, to increase a total heat dissipation area of the heat dissipation apparatus 7, and improve effect of the heat dissipation apparatus 7 for dissipating the heat of the chip 3.

As shown in FIG. 12, in a solution in which the heat dissipation fin 74 is installed on an outer surface of the top of the heat dissipation base 71, the mounting plate 72 on an outer surface of the side wall of the heat dissipation base 71 may be fastened to a root of the heat dissipation fin 74. For example, as shown in FIG. 12, the mounting plate 72 may be located at the root of the heat dissipation fin 74 adjacent to the side wall of the heat dissipation base 71. Certainly, as shown in FIG. 11, the mounting plate 72 may alternatively be located on an outer surface that is of the side wall of the heat dissipation base 71 and that is close to the heat dissipation base 71. A specific installation position of the mounting plate 72 is not limited in this embodiment, provided that the bottom of the heat dissipation base 71 can be located in the opening 12, and the mounting plate 72 can be mounted on the outer surface of the first housing wall 11.

Because the heat dissipation apparatus 7 is detachably installed in the opening 12 of the heat dissipation housing 1, to improve dustproof and waterproof performance of the electronic device, correspondingly, as shown in FIG. 12, a seal 9 is disposed between the side wall of the heat dissipation base 71 and an inner wall of the opening 12.

In an example, the seal 9 matches the heat dissipation base 71. For example, the heat dissipation base 71 is rectangular, and the seal 9 is a rectangular ring and can be sleeved on the side wall of the heat dissipation base 71. Then, when the heat dissipation base 71 is installed in the opening 12 of the heat dissipation housing 1, the seal 9 is located between the side wall of the heat dissipation base 71 and the inner wall of the opening 12, so that dust, water, and the like can be prevented from entering the chamber 101 through a gap between an outer wall of the heat dissipation base 71 and the inner wall of the opening 12.

In the electronic device shown in FIG. 9, the heat dissipation apparatus 7 passes through the opening 12 and is located on the surface of the chip 3. The elastic member 6 in the compressed state that is located on the outer surface of the mounting plate 72 of the heat dissipation apparatus 7 applies elastic force to the heat dissipation apparatus 7, so that a large portion of the gap between the chip 3 and the heat dissipation base 71 can be eliminated, and the chip 3 and the heat dissipation base 71 can fit more closely to each other. Once the chip 3 and the heat dissipation base 71 fit more closely to each other, heat transfer between the chip 3 and the heat dissipation base 71 is accordingly faster, so that the heat dissipation base 71 can quickly absorb heat of the chip 3 and dissipate the heat of the chip 3, to further improve heat dissipation effect of the electronic device.

As shown in FIG. 10, even if the thermal interface material layer 4 is filled between the chip 3 and the heat dissipation base 71, the thickness of the filled thermal interface material layer 4 is small, for example, in a range of only 0.05 millimeter to 0.07 millimeter, and the thermal resistance of the thermal interface material layer 4 is small. In view of this, thermal conductivity of the thermal interface material layer 4 can be improved, to further improve heat dissipation effect of the electronic device.

In addition, because the bottom of the mounting plate 71 of the heat dissipation apparatus 7 is in contact with the outer surface of the first housing wall 11, and an end of the mounting plate 71 is in contact with the housing heat dissipation fin 16 on the first housing wall 11, the heat dissipation apparatus 7 and the heat dissipation housing 1 can be thermally connected, so that the heat absorbed by the heat dissipation apparatus 7 from the chip 3 can also be transferred to the heat dissipation housing 1, to dissipate the heat by the heat dissipation housing 1. It can be learned that, both the heat dissipation apparatus 7 and the heat dissipation housing 1 can dissipate the heat of the chip 3, to enhance effect of dissipating the heat of the chip 3.

In this way, heat generated by the chip 3 can be quickly transferred to the heat dissipation apparatus 7. One portion of heat absorbed by the heat dissipation apparatus 7 is dissipated by itself, and the another portion can be transferred to the heat dissipation housing 1 through contact between the mounting plate 72 and the first housing wall 11, and is dissipated by the heat dissipation housing 1. It can be learned that, both the heat dissipation apparatus 7 and the heat dissipation housing 1 can dissipate the heat of the chip 3, to enhance the effect of dissipating the heat of the chip 3.

For a schematic diagram of a structure of another electronic device, refer to FIG. 10. The electronic device includes not only the heat dissipation housing 1, the circuit board 2, and the chip 3, but also the thermal interface material layer 4, the elastic member 6, and the heat dissipation apparatus 7. The circuit board 2 is fastened in the chamber 101 of the heat dissipation housing 1. The chip 3 is located on a surface of the circuit board 2. The thermal interface material layer 4 is located on a surface that is of the chip 3 and that is away from the circuit board 2. The first housing wall 11 of the heat dissipation housing 1 is provided with the opening 12 at a position corresponding to the chip 3. The bottom of the heat dissipation base 71 of the heat dissipation apparatus 7 is in the opening 12 and the heat dissipation base 71 is located on a surface of the thermal interface material layer 4. The mounting plate 72 of the heat dissipation apparatus 7 is mounted on an outer surface of the first housing wall 11. The elastic member 6 is located on an outer surface of the mounting plate 72. Both the elastic member 6 and the mounting plate 72 are fastened to the first housing wall 11 by using the fastener 8. The elastic member 6 is in a compressed state, specifically, compressed between the top of the fastener 8 and the mounting plate 72.

For descriptions of the electronic device having such a structure, refer to the foregoing descriptions of FIG. 9 to FIG. 12. Details are not described herein again.

In the electronic device, the heat dissipation apparatus 7 passes through the opening 12 and is located on the surface of the chip 3. The outer surface of the mounting plate 72 of the heat dissipation apparatus 7 has the elastic member 6 in the compressed state. Elastic force applied by the elastic member 6 to the heat dissipation apparatus 7 can eliminate a large portion of the gap between the chip 3 and the heat dissipation base 71. Although the thermal interface material layer 4 is filled between the chip 3 and the heat dissipation base 71, a thickness of the filled thermal interface material layer 4 is small, for example, in a range of only 0.05 millimeter to 0.07 millimeter, and thermal resistance of the thermal interface material layer 4 is small. In view of this, thermal conductivity of the thermal interface material layer 4 can be improved, to further improve heat dissipation effect of the electronic device.

In addition, because the bottom of the mounting plate 71 of the heat dissipation apparatus 7 is in contact with the outer surface of the first housing wall 11, and an end of the mounting plate 71 is in contact with the housing heat dissipation fin 16 on the first housing wall 11, the heat dissipation apparatus 7 and the heat dissipation housing 1 can be thermally connected, so that heat absorbed by the heat dissipation apparatus 7 from the chip 3 can also be transferred to the heat dissipation housing 1, to dissipate the heat by the heat dissipation housing 1. It can be learned that, both the heat dissipation apparatus 7 and the heat dissipation housing 1 can dissipate the heat of the chip 3, to enhance effect of dissipating the heat of the chip 3.

In this way, heat generated by the chip 3 can be quickly transferred to the heat dissipation apparatus 7. One portion of heat absorbed by the heat dissipation apparatus 7 is dissipated by itself, and the another portion can be transferred to the heat dissipation housing 1 through contact between the mounting plate 72 and the first housing wall 11, and is dissipated by the heat dissipation housing 1. It can be learned that, both the heat dissipation apparatus 7 and the heat dissipation housing 1 can dissipate the heat of the chip 3, to enhance the effect of dissipating the heat of the chip 3.

For a schematic diagram of a structure of another electronic device, refer to FIG. 13 to FIG. 15.

As shown in FIG. 13, the electronic device includes the heat dissipation housing 1, the circuit board 2, the chip 3, and the elastic member 6. The circuit board 2, the chip 3, and the elastic member 6 are all located in the chamber 101 formed by the heat dissipation housing 1. The chip 3 is located on a surface of the circuit board 2. The elastic member 6 is compressed between the circuit board 2 and the second housing wall 13 of the heat dissipation housing 1, to reduce a gap between the chip 3 and the first housing wall 11 of the heat dissipation housing 1.

The first housing wall 11 is a housing wall that is of the heat dissipation housing 1 and that is opposite to the chip 3 in position. The second housing wall 13 is a housing wall that is of the heat dissipation housing 1 and that is opposite to the circuit board 2 in position. Because the chip 3 is located on the surface of the circuit board 2, the second housing wall 13 is opposite to the first housing wall 11 in position.

The elastic member 6 may be any component having compression elasticity, for example, may be a spring.

As shown in FIG. 13, both the circuit board 2 and the chip 3 are located in the chamber 101. The chip 3 is located on the surface of the circuit board 2. The chip 3 is opposite to the first housing wall 11 in position. The circuit board 2 is opposite to the second housing wall 13 in position. The elastic member 6 in a compressed state is installed between a surface that is of the circuit board 2 and that is away from the chip 3 and an inner surface of the second housing wall 13.

There are a plurality of manners for installing the elastic member 6 in the chamber 101. For example, one manner may be that one end of the elastic member 6 is welded to the surface that is of the circuit board 2 and that is away from the chip 3, and the other end of the elastic member 6 is welded to the inner surface of the second housing wall 13. For another example, another manner may be that the elastic member 6 is fastened between the circuit board 2 and the second housing wall 13 by using a screw. For example, the screw passes through the elastic member 6, one end of the screw is fastened to the circuit board 2, and the other end is fastened to the second housing wall 13. A specific manner of installing the elastic member 6 in the chamber 101 is not limited, provided that the elastic member 6 can be compressed and located between the circuit board 2 and the second housing wall 13, and can apply, to the circuit board 2, elastic force toward the chip 3.

In this way, through elasticity applied to the circuit board 2 by the elastic member 6, the gap between the chip 3 and the first housing wall 11 can be reduced, to make the chip 3 and the first housing wall 11 fit more closely to each other. Once the chip 3 and the first housing wall 11 fit more closely to each other, heat transfer between the chip 3 and the first housing wall 11 is accordingly faster, so that the heat dissipation housing 1 can quickly absorb heat of the chip 3 and dissipate the heat of the chip 3, to further improve heat dissipation effect of the electronic device.

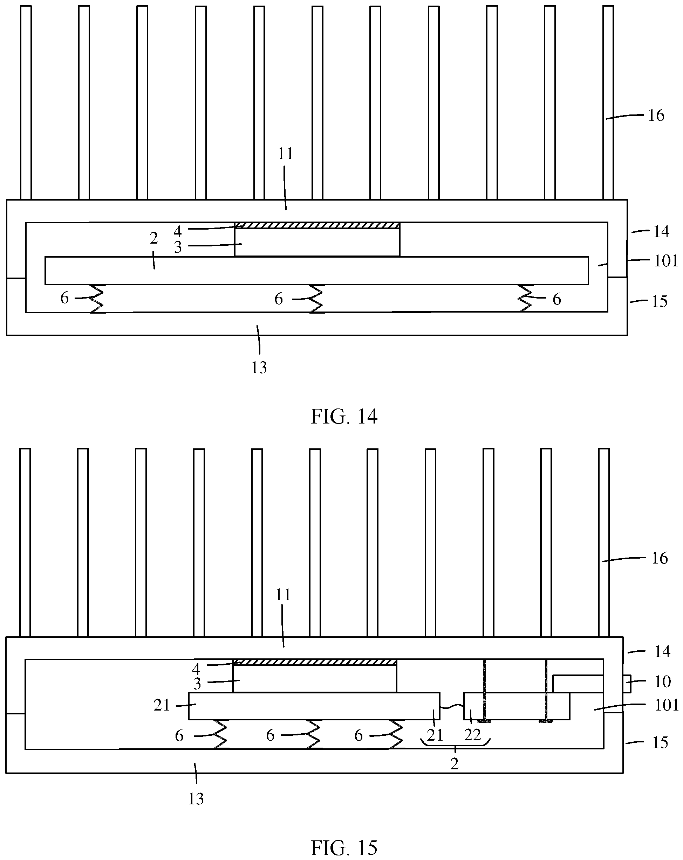

To further reduce the gap between the chip 3 and the first housing wall 11, correspondingly, as shown in FIG. 14, the thermal interface material layer 4 is filled between the chip 3 and the first housing wall 11. The thermal interface material layer 4 is a flexible material and has thermal conductivity. For example, the thermal interface material layer 4 may be silica gel, silicone grease, gel, or the like. A specific material of the thermal interface material layer 4 is not limited in this embodiment, provided that the thermal interface material layer 4 can reduce the gap and implement heat conduction effect.

Although the thermal interface material layer 4 is filled between the chip 3 and the first housing wall 11 of the electronic device, because the elastic member 6 in a compressed state that is disposed between the circuit board 2 and the second housing wall 13 applies, to the circuit board 2, elastic force toward the chip 3, a large portion of the gap between the chip 3 and the first housing wall 11 has been eliminated. In this case, only the thin thermal interface material layer 4 needs to be filled in the gap. For example, a thickness of the filled thermal interface material layer 4 is 0.05 millimeter to 0.07 millimeter, or even smaller.

In addition, because the thin thermal interface material layer 4 filled between the chip 3 and the first housing wall 11 has compression and deformation characteristics, and the elastic members 6 applies elastic force to the circuit board 2, the thickness of the thermal interface material layer 4 can be further reduced, so that the thermal interface material layer 4 is further thinned. For example, the thermal interface material layer 4 that is made of the silica gel and with a thickness of 0.07 millimeter is selected and filled between the chip 3 and the first housing wall 11. The thermal interface material layer 4 is compressed by 0.02 millimeter in thickness again under a pressing action of the elastic member 6. In this case, the thickness of the thermal interface material layer 4 finally filled between the chip 3 and the first housing wall 11 is 0.05 millimeter.

It can be learned that, the elastic member 6 in the compressed state that is installed between the circuit board 2 and the second housing wall 13 can eliminate the large portion of the gap between the chip 3 and the first housing wall 11, and can greatly reduce the thickness of the thermal interface material layer 4 filled between the chip 3 and the first housing wall 11. Once the thickness of the thermal interface material layer 4 is reduced, thermal resistance of the thermal interface material layer 4 is also reduced. Once the thermal resistance of the thermal interface material layer 4 is reduced, thermal conductivity of the thermal interface material layer 4 can be improved, to further improve the heat dissipation effect of the electronic device.

For example, in a solution in which the elastic member 6 is not disposed, a thermal interface material layer 4 with a thickness of 1 millimeter to 1.5 millimeter needs to be disposed between the chip 3 and the first housing wall 11. In a solution in which the elastic member 6 in the compressed state is disposed between the circuit board 2 and the second housing wall 13, the thermal interface material layer 4 with a thickness of only 0.05 millimeter to 0.07 millimeter needs to be disposed between the chip 3 and the first housing wall 11. It can be learned that, the thickness of the thermal interface material layer 4 in the former case is significantly greater than that of the thermal interface material layer 4 in the latter case. In this case, the thermal resistance of the thermal interface material layer 4 in the former case is also greater than that of the thermal interface material layer 4 in the latter case. Further, heat transfer performance of the thermal interface material layer 4 in the latter case is higher than that of the thermal interface material layer 4 in the former case.

As shown in FIG. 13 and FIG. 14, the circuit board 2 is fastened in the chamber 101 by using the elastic member 6. When the elastic member 6 performs a telescopic movement, the circuit board 2 also shakes with the elastic member 6, which may affect normal operation of other components on the surface of the circuit board 2, particularly installation sealing performance at an interface component.

To overcome the foregoing problem, the circuit board 2 may be divided into at least two sub-boards, the chip 3 alone occupies one sub-board, and other components occupy another sub-board. The sub-board on which the chip 3 is located is flexibly fastened in the chamber 101 by using the elastic member 6. The sub-board on which the other components are located is rigidly fastened in the chamber 101. However, for an electronic device in which the circuit board 2 is large, the circuit board 2 may be further divided into more sub-boards, the chip 3 alone occupies one sub-board, and other components occupy a plurality of remaining sub-boards. In this embodiment, a quantity of sub-boards included in the circuit board 2 is not limited, and an example in which a first sub-board and a second sub-board are included may be used. The first sub-board is a sub-board on which the chip 3 is located, and a quantity of the first sub-boards matches a quantity of the chips 3. The second sub-board is a sub-board on which the other components are located, and a quantity of the second sub-boards is related to a quantity of the other components, and there may be one or more second sub-boards.

As shown in FIG. 15, the circuit board 2 includes a first sub-board 21 and a second sub-board 22. The first sub-board 21 and the second sub-board 22 are electrically connected. The chip 3 is located on a surface of the first sub-board 21, and the elastic member 6 is compressed between the first sub-board 21 and the second housing wall 13. The second sub-board 22 is fastened on a housing wall of the heat dissipation housing 1, and an interface component 10 of the electronic device is located on a surface of the second sub-board 22.

There is one or more first sub-boards 21, which is mainly related to a quantity of chips 3. For example, if there is one chip 3, there is also one first sub-board 21. For another example, if there are a plurality of chips 3, there may be one first sub-board 21, and the plurality of chips 3 are all located on the first sub-board 21. For another example, there are a plurality of chips 3, there are also a plurality of first sub-boards 21, and the chips 3 are in a one-to-one correspondence with the first sub-boards 21. A quantity of the first sub-boards 21 is not limited in this embodiment, and a skilled person may flexibly select the quantity of the first sub-boards based on an actual situation.

There is one or a plurality of second sub-boards 22, which is mainly related to a quantity of components in the electronic device. For example, if there is a large quantity of components, there may be the plurality of second sub-boards 22. A quantity of the second sub-boards 22 is not limited in this embodiment, and a skilled person may flexibly select the quantity of the second sub-boards based on an actual situation.

In the accompanying drawings, one first sub-board 21 and one second sub-board 22 may be used as an example.

As shown in FIG. 15, the chip 3 is welded to the surface of the first sub-board 21 in the plurality of circuit boards 2, and the elastic member 6 is compressed between the first sub-board 21 and the second housing wall 13. The interface component 10 is welded to the surface of the second sub-board 22, and the second sub-board 22 is securely fastened in the chamber 101. In terms of an electrical connection relationship, the first sub-board 21 and the second sub-board 22 may be electrically connected by using a flexible cable, or the first sub-board 21 and the second sub-board 22 may be electrically connected by using a flexible circuit board.

In this way, due to elastic force of the elastic member 6 against the first sub-board 21, the large portion of the gap between the chip 3 and the first housing wall 11 can be eliminated, to make heat transfer faster between the chip 3 and the first housing wall 11. Even if the thermal interface material layer 4 is filled between the chip 3 and the first housing wall 11, the thickness of the filled thermal interface material layer 4 is small, for example, in a range of 0.05 millimeter to 0.07 millimeter, and the thermal resistance of the thermal interface material layer 4 is small. In view of this, heat transfer between the chip 3 and the first housing wall 11 can still be faster, to enhance effect of dissipating heat of the chip 3.

For the interface component 10, because the interface component 10 is located on the surface of the second sub-board 22 and does not need to shake with the elastic member 6, a gap does not need to be reserved between the interface component 10 and a mounting port through which the interface component is installed. In this way, sealing performance between the interface component 10 and the mounting port can be ensured, to implement dustproof and waterproof effect.

For a schematic diagram of a structure of another electronic device, refer to FIG. 14 and FIG. 15.

As shown in FIG. 14, the electronic device includes the heat dissipation housing 1, the circuit board 2, the chip 3, the thermal interface material layer 4, and the elastic member 6. The circuit board 2, the chip 3, the thermal interface material layer 4, and the elastic member 6 are all located in the chamber 101 formed by the heat dissipation housing 1. The chip 3 is located on a surface of the circuit board 2. The thermal interface material layer 4 is located on a surface that is of the chip 3 and that is away from the circuit board 2. The elastic member 6 is compressed between the circuit board 2 and the second housing wall 13 of the heat dissipation housing 1, to reduce a gap between the chip 3 and the first housing wall 11 of the heat dissipation housing 1.

The first housing wall 11 is a housing wall that is of the heat dissipation housing 1 and that is opposite to the chip 3 in position. The second housing wall 13 is a housing wall that is of the heat dissipation housing 1 and that is opposite to the circuit board 2 in position. The second housing wall 13 is opposite to the first housing wall 11 in position.

For descriptions of the electronic device having such a structure, refer to the foregoing descriptions. Details are not described one by one herein again.

In the electronic device, the elastic member 6 compressed between the circuit board 2 and the second housing wall 13 applies elastic force to the circuit board 2, so that a large portion of the gap between the chip 3 and the first housing wall 11 can be eliminated, and the chip 3 and the first housing wall 11 can fit more closely to each other. Once the chip 3 and the first housing wall 11 fit more closely to each other, heat transfer between the chip 3 and the first housing wall 11 is accordingly faster, so that the first housing wall 11 can quickly absorb heat of the chip 3 and dissipate the heat of the chip 3, to further improve heat dissipation effect of the electronic device.

Even if the thermal interface material layer 4 is filled between the chip 3 and the first housing wall 11, a thickness of the filled thermal interface material layer 4 is small, for example, in a range of only 0.05 millimeter to 0.07 millimeter, and thermal resistance of the thermal interface material layer 4 is small. In view of this, thermal conductivity of the thermal interface material layer 4 can be improved, to further improve the heat dissipation effect of the electronic device.

The foregoing descriptions are merely embodiments of this application, but are not intended to limit this application. Any modification, equivalent replacement, or improvement made without departing from the spirit and principle of this application should fall within the protection scope of this application.

## Claims

1. An electronic device, wherein the electronic device comprises a heat dissipation housing (1), a circuit board (2), a chip (3), a thermal interface material layer (4), a heat conducting member (5), and an elastic member (6), wherein
the circuit board (2), the chip (3), the thermal interface material layer (4), the heat conducting member (5), and the elastic member (6) are all located in a chamber (101) formed by the heat dissipation housing (1), the chip (3) is located on a surface of the circuit board (2), and the heat conducting member (5) is located on a surface that is of the chip (3) and that is away from the circuit board (2); and
the elastic member (6) is compressed between a surface that is of the heat conducting member (5) and that is away from the chip (3) and an inner surface of a first housing wall (11) of the heat dissipation housing (1), to reduce a gap between the chip (3) and the heat conducting member (5), the gap is filled with the thermal interface material layer (4), the elastic member (6) has a heat transfer property, and the first housing wall (11) is a housing wall that is of the heat dissipation housing (1) and that is opposite to the chip (3) in position.

2. The electronic device according to claim 1, wherein the elastic member (6) comprises a spring (61) and a heat pipe (62), wherein
the spring (61) is compressed between the heat conducting member (5) and the first housing wall (11), to reduce the gap between the chip (3) and the heat conducting member (5);
the heat pipe (62) is connected between the heat conducting member (5) and the first housing wall (11) to transfer, to the heat dissipation housing (1), heat absorbed by the heat conducting member (5) from the chip (3); and
the heat pipe (62) has elasticity, and the heat pipe (62) is compressed between the surface that is of the heat conducting member (5) and that is away from the chip (3) and the inner surface of the first housing wall (11) of the heat dissipation housing (1).

3. The electronic device according to claim 2, wherein the heat pipe (62) comprises a first pipe section (621), a second pipe section (622), and a third pipe section (623), wherein
the first pipe section (621) is attached to the surface that is of the heat conducting member (5) and that is away from the chip (3), the third pipe section (623) is attached to the inner surface of the first housing wall (11), and the second pipe section (622) is obliquely connected between the first pipe section (621) and the second pipe section (622).

4. The electronic device according to any one of claims 1 to 3, wherein the elastic member (6) is a bent heat conduction sheet, and is compressed and disposed between the surface that is of the heat conducting member (5) and that is away from the chip (3) and the inner surface of the first housing wall (11), and the elastic member (6) provides elasticity through a bending characteristic, and transfers heat through a heat conduction characteristic.

5. The electronic device according to any one of claims 1 to 4, wherein the circuit board (2) is fastened to a housing wall of the heat dissipation housing (1).

6. An electronic device, wherein the electronic device comprises a heat dissipation housing (1), a circuit board (2), a chip (3), a heat conducting member (5), and an elastic member (6), wherein
the circuit board (2), the chip (3), the heat conducting member (5), and the elastic member (6) are all located in a chamber (101) formed by the heat dissipation housing (1), the chip (3) is located on a surface of the circuit board (2), and the heat conducting member (5) is located on a surface that is of the chip (3) and that is away from the circuit board (2); and
the elastic member (6) is compressed between a surface that is of the heat conducting member (5) and that is away from the chip (3) and an inner surface of a first housing wall (11) of the heat dissipation housing (1), to reduce a gap between the chip (3) and the heat conducting member (5), the elastic member (6) has a heat transfer property, and the first housing wall (11) is a housing wall that is of the heat dissipation housing (1) and that is opposite to the chip (3) in position.

7. The electronic device according to claim 6, wherein the electronic device further comprises a thermal interface material layer (4); and
the thermal interface material layer (4) is filled in the gap between the chip (3) and the heat conducting member (5).

8. An electronic device, wherein the electronic device comprises a heat dissipation housing (1), a circuit board (2), a chip (3), a thermal interface material layer (4), an elastic member (6), and a heat dissipation apparatus (7), wherein
the circuit board (2), the chip (3), and the thermal interface material layer (4) are all located in a chamber (101) formed by the heat dissipation housing (1), and the chip (3) is located on a surface of the circuit board (2);
a first housing wall (11) of the heat dissipation housing (1) has an opening (12) at a position corresponding to the thermal interface material layer (4), and the first housing wall (11) is a housing wall that is of the heat dissipation housing (1) and that is opposite to the chip (3) in position;
the heat dissipation apparatus (7) comprises a heat dissipation base (71) and a mounting plate (71), and the mounting plate (71) is located on an outer surface of a side wall of the heat dissipation base (71);
the heat dissipation base (71) matches the opening (12), the heat dissipation base (71) is detachably disposed in the opening (12), the heat dissipation base (71) is located on a surface that is of the chip (3) and that is away from the circuit board (2), and the mounting plate (72) is located on an outer surface of the first housing wall (11);
the elastic member (6) is located on a surface that is of the mounting plate (72) and that is away from the first housing wall (11), and both the elastic member (6) and the mounting plate (72) are fastened to the first housing wall (11) by using a fastener (8); and
the elastic member (6) is compressed between the fastener (8) and the mounting plate (72), to reduce a gap between the chip (3) and the heat dissipation base (71), and the gap is filled with the thermal interface material layer (4).

9. The electronic device according to claim 8, wherein a vapor chamber (73) is disposed on a surface that is of the heat dissipation base (71) and that is close to the chip (3).

10. The electronic device according to claim 8 or 9, wherein the heat dissipation apparatus (7) further comprises a heat dissipation fin (74), and the heat dissipation fin (74) is located on a surface that is of the heat dissipation base (71) and that is away from the chip (3).

11. The electronic device according to any one of claims 8 to 10, wherein an end that is of the mounting plate (72) and that is away from the side wall of the heat dissipation base (71) is in contact with a housing heat dissipation fin (16) of the heat dissipation housing (1).

12. The electronic device according to any one of claims 8 to 11, wherein a seal (9) is disposed between the side wall of the heat dissipation base (71) and an inner wall of the opening (12).

13. The electronic device according to any one of claims 8 to 12, wherein the circuit board (2) is fastened to a housing wall of the heat dissipation housing (1).

14. An electronic device, wherein the electronic device comprises a heat dissipation housing (1), a circuit board (2), a chip (3), an elastic member (6), and a heat dissipation apparatus (7), wherein
both the circuit board (2) and the chip (3) are located in a chamber (101) formed by the heat dissipation housing (1), and the chip (3) is located on a surface of the circuit board (2);
a first housing wall (11) of the heat dissipation housing (1) has an opening (12) at a position corresponding to the chip (3), and the first housing wall (11) is a housing wall that is of the heat dissipation housing (1) and that is opposite to the chip (3) in position;
the heat dissipation apparatus (7) comprises a heat dissipation base (71) and a mounting plate (72), and the mounting plate (72) is located on an outer surface of a side wall of the heat dissipation base (71);
the heat dissipation base (71) matches the opening (12), the heat dissipation base (71) is detachably disposed in the opening (12), the heat dissipation base (71) is located on a surface that is of the chip (3) and that is away from the circuit board (2), and the mounting plate (72) is located on an outer surface of the first housing wall (11);
the elastic member (6) is located on a surface that is of the mounting plate (72) and that is away from the first housing wall (11), and both the elastic member (6) and the mounting plate (72) are fastened to the first housing wall (11) by using a fastener (8); and
the elastic member (6) is compressed between the fastener (8) and the mounting plate (72), to reduce a gap between the chip (3) and the heat dissipation base (71).

15. The electronic device according to claim 14, wherein the electronic device further comprises a thermal interface material layer (4); and
the thermal interface material layer (4) is filled in the gap between the chip (3) and the heat dissipation base (71).

16. An electronic device, wherein the electronic device comprises a heat dissipation housing (1), a circuit board (2), a chip (3), a thermal interface material layer (4), and an elastic member (6), wherein
the circuit board (2), the chip (3), the thermal interface material layer (4), and the elastic member (6) are all located in a chamber (101) formed by the heat dissipation housing (1), and the chip (3) is located on a surface of the circuit board (2); and
the elastic member (6) is compressed between the circuit board (2) and a second housing wall (13) of the heat dissipation housing (1), to reduce a gap between the chip (3) and a first housing wall (11) of the heat dissipation housing (1), the gap is filled with the thermal interface material layer (4), the first housing wall (11) is a housing wall that is of the heat dissipation housing (1) and that is opposite to the chip (3) in position, and the second housing wall (13) is opposite to the first housing wall (11) in position.

17. The electronic device according to claim 16, wherein the circuit board (2) comprises a first sub-board (21) and a second sub-board (22), and the first sub-board (21) and the second sub-board (22) are electrically connected;
the chip (3) is located on a surface of the first sub-board (21), and the elastic member (6) is compressed between the first sub-board (21) and the second housing wall (13); and
the second sub-board (22) is fastened to a housing wall of the heat dissipation housing (1), and an interface component (10) of the electronic device is located on a surface of the second sub-board (22).

18. An electronic device, wherein the electronic device comprises a heat dissipation housing (1), a circuit board (2), a chip (3), and an elastic member (6), wherein
the circuit board (2), the chip (3), and the elastic member (6) are all located in a chamber (101) formed by the heat dissipation housing (1), and the chip (3) is located on a surface of the circuit board (2); and
the elastic member (6) is compressed between the circuit board (2) and a second housing wall (13) of the heat dissipation housing (1), to reduce a gap between the chip (3) and a first housing wall (11) of the heat dissipation housing (1), the first housing wall (11) is a housing wall that is of the heat dissipation housing (1) and that is opposite to the chip (3) in position, and the second housing wall (13) is opposite to the first housing wall (11) in position.

19. The electronic device according to claim 18, wherein the electronic device further comprises a thermal interface material layer (4); and
the thermal interface material layer (4) is filled in the gap between the chip (3) and the first housing wall (11).
